# EUROPEAN PATENT APPLICATION

(11) **EP 1 860 504 A1**
(43) Date of publication of application: **28.11.2007**
(21) Application number: 06745366.2
(22) Date of filing: 16.03.2006
(51) Int. Cl.: G03F 7/004, G03F 7/027, G03H 1/02

(54) **PHOTOSENSITIVE COMPOSITION CONTAINING ORGANIC FINE PARTICLES**

(30) Priority: 18.03.2005 JP 2005079352; 28.03.2005 JP 2005092988; 22.11.2005 JP 2005337416
(71) Applicant: National University Corporation The University of Electro - Communications, Chofu-shi, Tokyo 182-8585 (JP); Nissan Chemical Industries, Ltd., Chiyoda-ku, Tokyo 101-0054 (JP)
(72) Inventor: TOMITA, Yasuo, N. U. Corp. Uni. of Elec.-Com., Chofu-shi, Tokyo (JP); FURUSHIMA, Kouji, N. U. Corp. Uni. of Elec.-Com., Chofu-shi, Tokyo (JP); AKIMOTO, Kazuhiko, Nissan Chem. Industries, Ltd., To yama-shi (JP); CHIKAMA, Katsumi, Nissan Chem. Industries, Ltd., Funabashi-shi, Chiba 274-8507 (JP); HIDAKA, Motohiko, Nissan Chem. Industries, Ltd., Funabashi-shi, Chiba 274-8507 (JP); ODOI, Keisuke, Nissan Chem. Industries, Ltd., Tokyo (JP)
(74) Representative: HOFFMANN EITLE
(86) International application number: PCT/JP2006/305246
(87) International publication number: WO 2006/101003

(57) **Abstract**

It is an object of the present invention to provide a photosensitive composition capable of forming permanent holograms with low light scattering loss and high diffraction efficiency, and a method for forming a pattern. A photosensitive composition and a pattern formation method using the photosensitive composition are **characterized in that** the photosensitive composition used to form a pattern by pattern exposure includes: (a) a polymerizable compound, (b) a photopolymerization initiator, and (c) organic fine particles.

## Description

### TECHNICAL FIELD

The present invention relates to a photosensitive composition capable of forming pattern, wherein pattern exposure generates movement among components in the composition and changes a spatial distribution of the components; a method for pattern formation using the composition; a hologram recording material composition for a hologram recording layer on which the photosensitive composition records a volume phase type hologram; the hologram recording layer; and a volume phase type hologram recording medium that includes the hologram recording layer.

### BACKGROUND ART

A holographic diffraction grating (hologram) records a light contrast (interference) pattern as a pattern of an index of refraction or absorption on photosensitive material or the like. Due to its multiple functions, there are reports of many applications of holograms in a wide range of fields such as photonics and information displays, including diffractive optical elements, holographic optical memories, narrowband wavelength filters, photonic crystals, light guide couplers, optical interconnections, stereoscopic image displays, and head-up displays.

In these applications, a high refractive index variation and recording sensitivity is normally required. In addition, low polymerization shrinkage is also required in order to suppress any deterioration in reproduced light quality due to mechanical deformation of the recorded hologram, which is caused by polymerization shrinkage as a result of polymerization during holographic exposure.

Dichromic acid gelatin photosensitive material and bleached silver halide photosensitive material have been used as typical hologram recording material compositions in the past. These have high diffraction efficiency, but the need for complex treatments during hologram creation, particularly wet developing treatment, is one drawback.
The OmniDex series from DuPont is a dry hologram photosensitive material being sold to overcome this drawback. This material mainly consists of a radical polymerization monomer, a binder polymer, a photoradical polymerization initiator, and a sensitizing dye, and records a hologram by utilizing the difference in the refractive indexes of the radical polymerization monomer and the binder polymer. In other words, by subjecting the photosensitive composition formed as a film to interference exposure, portions exposed to strong light start to undergo radical polymerization resulting in a concentration gradient for the radical polymerization monomer, and radical polymerization monomers diffuse and move from portions exposed to weak light to the portions exposed to strong light. As a consequence, the degree of the radical polymerization monomer density and the polymerized polymer density can be determined depending on the weakness or strength of interference light, whereby a hologram is formed based on the difference between the refractive indices of these and the binder polymer. This material system performs best as a photopolymer for holograms currently reported, but is also noted for being limited to a thickness of approximately 30 µm and having problems regarding heat resistance and transparency.

There have also been reports on a material system that combine radical polymerization and cationic polymerization (see Patent Document 1) and a material system that employ cationic polymerization (see Patent Document 2). However, these are formed from organic materials only, and the polymers are not mutually compatible at the molecular level. Therefore, a hologram recording film formed using such material systems may have reduced transparency due to phase separation, and thus experience problems such as increased light scattering loss. Furthermore, the mechanical strength and environmental stability of such materials is still inadequate.
In addition, a material system has been disclosed that combines a photopolymerizable monomer and a network of inorganic substances (see Patent Document 3). In cases where the inorganic material forming the network is used as a binder, the advantages of excellent heat resistance, environmental resistance, and mechanical strength are obtained, as well as the achievement of a large difference with the refractive index of the photopolymerizable organic monomer. However, a hologram recording film formed using this material system tends to exhibit the problems of brittleness, and inferior performance in terms of flexibility, workability, and coating suitability. There is also poor compatibility between the inorganic binder and the organic monomer. Thus, it is hard to make adjustments for a uniform coating material.
A material that diffuses metallic ultra fine particles in a solid matrix has also been disclosed as a hologram recording material (see Patent Document 4). However, in this invention, the matrix must possess flowability and has poor solidarity, as well as problems such as poor interface adherence between the metallic particle surface and the solid matrix, brittleness, and moisture penetration to interfaces.
A hologram recording material that uses an organic-inorganic hybrid polymer and organic metallic fine particles having a photopolymerizable group has been disclosed (see Patent Document 5). However, in this invention, heating and ultraviolet polymerization are required to fix the interference fringes, which brings up issues regarding application to industrial processes.
A hologram recording material that diffuses inorganic fine particles in photopolymerizable monomers has been disclosed as material for recording a hologram through a simpler method (see Patent Document 6 and Non-Patent Document 1). However, in this invention, there is large light scattering loss due to the large particle size and the wide width of the particle size distribution of the inorganic fine particles used. A material that reduces the particle size of the inorganic fine particles used and lowers the light scattering loss in order to overcome this problem has been reported (see Non-Patent Document 2). However, secondary aggregation of the inorganic fine particles occurs in the photopolymerizable monomers, which leaves the problems of securing material stability and performance.
A volume hologram laminated body that uses organic fine particles has been reported (see Patent Document 7). In this invention, the organic fine particles are used for the purpose of improving security by decreasing the film strength of the hologram layer and increasing vulnerability. Therefore, it is necessary to use a material whose refractive index is generally equivalent to that of the photosensitive material used in the hologram layer. Otherwise, it is impossible to create a difference in the refractive indices from particle movement during interference exposure with a photosensitizing agent. Also, the organic fine particles used are so-called linear polymer fine particles, and thus have low compatibility with photosensitive material and low transparency.
A photosensitive composition for volume hologram recording that uses organic fine particles has been reported (see Patent Document 8). In this invention, organic fine particles with a particle size of 100 nm or more are used in the volume hologram layer for the purpose of achieving brittleness. The organic fine particles are normally linear polymer fine particles, but a particle size less than 100 nm makes the photosensitive composition bulky and thus difficult to add to photosensitive material, whereas a particle size of 100 nm or more results in large light scattering loss. In addition, since the photosensitive composition is a material system that combines radical polymerization and cationic polymerization, the polymers are not mutually compatible at the molecular level. Therefore, a hologram recording film formed using such a material system may have reduced transparency due to phase separation, and thus experience problems such as increased scattering loss.
A hologram recording material composition has been reported that describes the use of organic fine particles as a thickening agent (see Patent Document 9). The fine particles used have a large particle size of 0.1 to 20 µm in order to obtain a thickening effect, but when used for the hologram recording layer, create the problem of less recording density due to scattering loss. Moreover, this invention employs a recording method that generates a refractive-index distribution from subjecting monomers with a high refractive index to interference exposure among polymers with a low refractive index. However, there is scattering loss due to layer separation after recording.
A laminated body that uses multi-branched polymer particles has been reported (see Patent Document 10). This invention creates a laminated body with a polymer fine particle layer through an alternating adsorption method that utilizes electrostatic interaction. However, pattern formation cannot be achieved by moving the particles using interference exposure.
Patent Document 1: Japanese Patent Application Publication No. JP-A-5-107999 (Claims)
Patent Document 2: U.S. Patent No. 5,759,721 Specification (All)
Patent Document 3: Japanese Patent Application Publication No. JP-A-6-019040 (Claims)
Patent Document 4: Japanese Translation of PCT International Application No. JP-T-2000-508783 (Claims)
Patent Document 5: Japanese Patent Application Publication No. JP-A-2002-236440 (Claims)
Patent Document 6: Japanese Patent Application Publication No. JP-A-2003-084651 (Claims)
Patent Document 7: Japanese Patent Application Publication No. JP-A-2004-004846 (Claims)
Patent Document 8: Japanese Patent Application Publication No. JP-A-2005-003794 (Claims)
Patent Document 9: Japanese Patent Application Publication No. JP-A-2003-029604 (Paragraph [0072])
Patent Document 10: Japanese Patent Application Publication No. JP-A-2003-094546 (Claims)
Non-Patent Document 1: Appl. Phys. Lett. 2002, vol. 81, p. 4121-4123
Non-Patent Document 2: Appl. Opt. 2004, vol. 43, p. 2125-2129

### DISCLOSURE OF THE INVENTION

### Problem to be Solved by the Invention

It is an object of the present invention to provide a photosensitive material capable of forming permanent holograms with low light scattering loss and high diffraction efficiency, and a method for forming a hologram.

### Means for Solving the Problem

Based the results of dedicated research, the inventors found that an excellent holographic diffraction grating (hologram) can be obtained from a photosensitive composition containing organic fine particles, a photopolymerization initiator, and a polymerizable compound, resulting in the present invention.
Namely, the present invention is a photosensitive composition including, according to a first aspect: (a) a polymerizable compound; (b) a photopolymerization initiator; and (c) organic fine particles.
According to a second aspect, the photosensitive composition described in the first aspect is used to form a pattern in which movement is generated between components by pattern exposure and a spatial distribution of the components is varied.
According to a third aspect, the photosensitive composition described in the first aspect is used to form a spatial refractive-index modulation pattern in which movement is generated between components by pattern exposure and a spatial distribution of the components is varied.
According to a fourth aspect, the photosensitive composition described in the first aspect is used to form a hologram by interference exposure.
According to a fifth aspect, in the photosensitive composition described in the first aspect, the polymerizable compound is a compound that gives polymers with a refractive index of 1.3 to 2.0 with respect to an interference exposure wavelength used for hologram recording.
According to a sixth aspect, in the photosensitive composition described in the first aspect, a difference between a refractive index of the organic fine particles with respect to an interference exposure wavelength for hologram recording and a refractive index of the polymers with respect to an interference exposure wavelength for hologram recording is not less than 0.001 and not more than 1.0.
According to a seventh aspect, in the photosensitive composition described in the first aspect, a difference between a refractive index of the organic fine particles with respect to an interference exposure wavelength for hologram recording and a refractive index of the polymers with respect to an interference exposure wavelength for hologram recording is not less than 0.01 and not more than 1.0.
According to an eighth aspect, in the photosensitive composition described in the first aspect, the organic fine particles have an average particle size that is not less than 1 nm and not more than 100 nm.
According to a ninth aspect, in the photosensitive composition described in the first aspect, the organic fine particles are hyperbranched polymers, dendrimers, or starburst polymers.
According to a tenth aspect, in the photosensitive composition described in the first aspect, the organic fine particles are hyperbranched polymers.
According to an eleventh aspect, in the photosensitive composition described in the first aspect, a ratio of mass of the organic fine particles to a total mass of the polymerizable compound, the photopolymerization initiator, and the organic fine particles is 3 mass% to 60 mass%.
According to a twelfth aspect, in the photosensitive composition described in the first aspect, the polymerizable compound is a compound with an ethylenically unsaturated bond, and the photopolymerization initiator is a photoradical polymerization initiator.
According to a thirteenth aspect, in the photosensitive composition described in the first aspect, the polymerizable compound is a compound with a cationic polymerizable region, and the photopolymerization initiator is a photoacid generator.
According to a fourteenth aspect, a hologram recording layer is obtained by coating the photosensitive composition described in the first aspect on a support.
According to a fifteenth aspect, a hologram recording medium includes: a support; a hologram recording layer obtained by coating the photosensitive composition described in the first aspect on the support; and a protective material covering an upper layer of the hologram recording layer.
According to a sixteenth aspect, in the hologram recording medium described in the fifteenth aspect, the support and the protective material are both transparent resin films.
According to a seventeenth aspect, a pattern formation method includes the steps of: coating the photosensitive composition described in the first aspect on a support to form a coating film; and subjecting the coating film to pattern exposure.
According to an eighteenth aspect, in the pattern formation method described in the seventeenth aspect, the pattern exposure is interference exposure.
According to a nineteenth aspect, a photosensitive composition is characterized by including: (a) a polymerizable compound; (b) a photopolymerization initiator; and (c) organic fine particles, wherein a spatial refractive-index modulation pattern is formed through movement of the polymerizable compound and the organic fine particles by pattern exposure.
According to a twentieth aspect, the photosensitive composition described in the nineteenth aspect is further characterized in that the organic fine particles are easily dissolved with the polymerizable compound.
According to a twenty-first aspect, in the photosensitive composition described in the nineteenth aspect, a difference between a refractive index of the organic fine particles with respect to an interference exposure wavelength for hologram recording and a refractive index of the polymers with respect to an interference exposure wavelength for hologram recording is not less than 0.01 and not more than 1.0.
According to a twenty-second aspect, in the photosensitive composition described in the nineteenth aspect, the organic fine particles have an average particle size that is not less than 1 nm and less than 100 nm.
According to a twenty-third aspect, in the photosensitive composition described in the nineteenth aspect, the organic fine particles are hyperbranched polymers or dendrimers.
According to a twenty-fourth aspect, in the photosensitive composition described in the twenty-third aspect, the organic fine particles are hyperbranched polymers represented by formula (1) or formula (2): 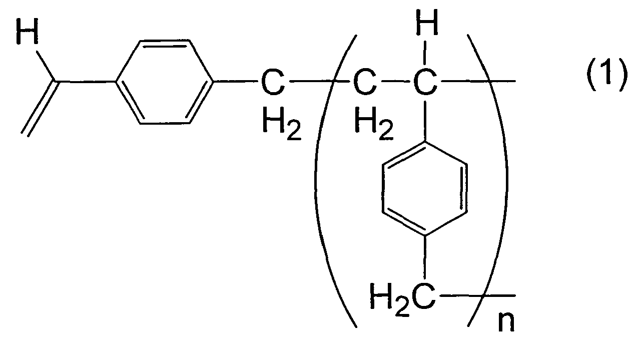 (wherein n indicates the number of repeated structural units, and is an integer from 2 to 100,000); and 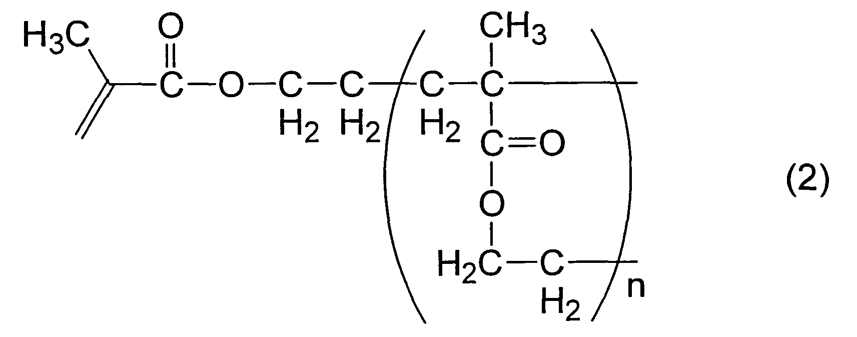 (wherein n indicates the number of repeated structural units, and is an integer from 2 to 100,000).

### Effects of the Invention

According to the present invention, it is possible to provide a photosensitive composition capable of forming a pattern by pattern exposure.
Subjecting the photosensitive composition of the present invention to pattern exposure enables the formation of a pattern due to changes in the spatial distribution of components among the composition. In particular, it is possible to form a hologram by interference exposure.
Furthermore, according to the present invention, it is possible to provide a hologram recording layer. Subjecting the hologram recording layer to interference exposure enables the recording of a hologram.
According to the present invention, it is also possible to provide a hologram with low light scattering loss and high diffraction efficiency.
With the hologram obtainable from the present invention, organic fine particles contained therein have a high degree of freedom with respect to material design. Therefore, it is possible to give the organic fine particles a optical function. Accordingly, the holographic diffraction grating is applicable as a multifunctional optical element in a wide range of fields such as photonics and information displays, including diffractive optical elements, holographic optical memories, narrowband wavelength filters, photonic crystals, light guide couplers, optical interconnections, stereoscopic image displays, and head-up displays. Moreover, by adding another chemical to the organic fine particles, the spatial sequence of the chemical can be achieved in a purely optical manner by a one-step process. Therefore, the holographic diffraction grating can also be applied to chemical or biological sensors, filters and the like.

### BRIEF DESCRIPTION OF THE DRAWINGS

FIG. 1 is a conceptual diagram of a hologram formation process;
FIG. 2 is a conceptual diagram of an apparatus for performing two-beam interference exposure with respect to a volume hologram recording medium;
FIG. 3 is a graph showing the change in exposure time of the diffraction efficiency of the volume hologram recording medium according to Example 1;
FIG. 4 is a graph showing the change in exposure time of the diffraction efficiency of the volume hologram recording medium according to Example 2;
FIG. 5 is a transmission electron microscope image showing the movement of particles within the volume hologram recording medium according to Example 3; and
FIG. 6 is a graph showing the change in exposure time of the diffraction efficiency of the volume hologram recording medium according to Comparative Example 1.

### Description of the Reference Numerals

- 1: HOLOGRAM RECORDING MEDIUM
- 2: Nd:YVO₄ LASER
- 3: BEAM EXPANDER
- 4: He-Ne LASER
- 5,6,7,8,9,10,11: MIRROR
- 12: BEAM SAMPLER
- 13 3: HALF MIRROR
- 14, 15: HALF-WAVE LENGTH PLATE
- 16,17: POLARIZING PRISM
- 18,19,20: LIGHT DETECTION UNIT

### BEST MODES FOR CARRYING OUT THE INVENTION

A photosensitive composition of the present invention contains (a) a polymerizable compound, (b) a photopolymerization initiator, and (c) organic fine particles. Descriptions of these components are given below.

### (a) Polymerizable compound

A polymerizable compound in the present invention is not particularly limited, provided that the compound has one or more, but preferably one to six, polymerizable regions within its molecules which are to be polymerized by the action of the photopolymerization initiator. The polymerizable region includes an ethylenically unsaturated bond being a radical polymerizable region. Alternatively, the polymerizable region includes a cationic polymerizable region, including a vinyl ether structure, a vinyl thioether structure, or a cyclic ether structure such as an epoxy ring or an oxetane ring.
It should be noted that a polymerizable compound in the present invention refers to a compound that is not a so-called polymer. Accordingly, a polymerizable compound according to the present invention includes not only strict monomeric compounds, but also dimers, trimers, oligomers, and reactive polymers.
Conceivable examples of such polymerizable compounds are compounds with an ethylenically unsaturated bond being a radical polymerizable region.
Alternatively, the polymerizable compound includes a compound with a cationic polymerizable region, including a vinyl ether structure, or an epoxy ring or an oxetane ring.
Among compounds with an ethylenically unsaturated bond, conceivable examples include an unsaturated carboxylic acid; an ester compound of an aliphatic polyhydroxy compound and an unsaturated carboxylic acid; an ester compound of an aromatic polyhydroxy compound and an unsaturated carboxylic acid; an ester compound obtained by an esterification reaction of a polyvalent hydroxy compound, such as an aliphatic polyhydroxy compound and an aromatic polyhydroxy compound, an unsaturated carboxylic acid, and a polyvalent carboxylic acid; and an amide compound of an aliphatic polyamine compound and an unsaturated carboxylic acid.
More specifically, an unsaturated fatty acid, an ester compound of an aliphatic polyhydroxy compound and an unsaturated carboxylic acid, as well as an ester compound of an aromatic polyhydroxy compound and an unsaturated carboxylic acid are conceivable.
Specific examples of an unsaturated fatty acid include phenoxyethylene glycol acrylate, phenoxydiethylene glycol acrylate, 2-hydroxy-3-phenoxypropyl acrylate, 3-chloro-2-hydroxypropyl methacrylate, 2-acrylyloxyethyl succinic acid, 2-acrylyloxyethyl phthalic acid, and isoboronyl acrylate. Also conceivable are a methacrylic acid ester compound that substitutes the acrylate portion of the acrylic acid ester compound with methacrylate, as well as an itaconic acid ester compound that substitutes itaconate, a crotonic acid ester compound that substitutes crotonate, and a maleic acid ester compound that substitutes maleate in a similar manner.
Specific examples of an ester compound of an aliphatic polyhydroxy compound and an unsaturated carboxylic acid include acrylic acid ester compounds such as ethylene glycol diacrylate, triethylene glycol diacrylate, trimethylolpropane triacrylate, trimethylolethane triacrylate, pentaerythritol diacrylate, pentaerythritol triacrylate, pentaerythritol tetraacrylate, dipentaerythritol tetraacrylate, dipentaerythritol pentaacrylate, dipentaerythritol hexaacrylate, and glycerol acrylate. Also conceivable are a methacrylic acid ester compound that substitutes the acrylate portion of the acrylic acid ester compound with methacrylate, as well as an itaconic acid ester compound that substitutes itaconate, a crotonic acid ester compound that substitutes crotonate, and a maleic acid ester compound that substitutes maleate in a similar manner.
Conceivable examples of an ester compound of an aromatic polyhydroxy compound and an unsaturated carboxylic acid include hydroquinone diacrylate, hydroquinone dimethacrylate, resorcin diacrylate, resorcin dimethacrylate, and pyrogallol triacrylate.
An ester compound obtained by an esterification reaction of a polyvalent hydroxy compound such as an aliphatic polyhydroxy compound and an aromatic polyhydroxy compound, an unsaturated carboxylic acid, and a polyvalent carboxylic acid, is not necessarily a single substance, and representative specific examples include a condensate of an acrylic acid, a phthalic acid, and ethylene glycol; a condensate of an acrylic acid, a maleic acid, and diethylene glycol; a condensate of a methacrylic acid, a terephthalic acid, and pentaerythritol; and a condensate of an acrylic acid, an adipic acid, and glycerin.
Conceivable examples of compounds with an ethylenically unsaturated bond are a urethane compound obtainable by reacting polyvalent isocyanate and a hydroxyalkyl unsaturated carboxylic acid ester; and a compound obtainable by reacting a polyvalent epoxy compound and a hydroxyalkyl unsaturated carboxylic acid ester.
As compounds with an ethylenically unsaturated bond used in the present invention, the following, for example, are useful: an acrylamide compound such as ethylene bisacrylamide; an allylic ester compound such as diallyl phthalate; and a vinyl group-containing compound such as vinyl phthalate.
Using an acrylic acid ester compound or a methacrylic acid ester compound as the compound with an ethylenically unsaturated bond in the present invention is particularly preferred.
These compounds with an ethylenically unsaturated bond may be used alone or in combination as necessary.
Among compounds with a vinyl ether structure, conceivable examples include vinyl-2-chloroethyl ether, vinyl n-butyl ether, triethylene glycol divinyl ether, 1,4-cyclohexanedimethanol divinyl ether, trimethylolethane trivinyl ether, and vinyl glycidyl ether.
Among compounds with an epoxy ring, conceivable examples include diglycerol polydiglycidyl ether, pentaerythritol polyglycidyl ether, 1,4-bis(2,3-epoxypropoxyperfluoroisopropyl)cyclohexane, sorbitol polyglycidyl ether, trimethylolpropane polyglycidyl ether, resorcin diglycidyl ether, 1,6-hexanediol diglycidyl ether, polyethylene glycol diglycidyl ether, phenyl glycidyl ether, p-tertiary-butylphenyl glycidyl ether, adipic acid diglycidyl ether, o-phthalic acid diglicidyl ether, dibromophenyl glycidyl ether, 1,2,7,8-diepoxyoctane, 1,6-dimethylolperfluorohexane diglycidyl ether, 4,4'-bis(2,3-epoxypropoxyperfluoroisopropyl)diphenyl ether, 2,2-bis(4-glycidyloxyphenyl)propane, 3,4-epoxycyclohexylmethyl-3',4'-epoxycyclohexane carboxylate, 3,4-epoxycyclohexyloxirane, 2-(3,4-epoxycyclohexyl)-3',4'-epoxy-1,3-dioxane-5-spirocyclohexane, 1,2-ethylenedioxy-bis(3,4-epoxycyclohexylmethane), 4',5'-epoxy-2'-methylcyclohexylmethyl-4,5-epoxy-2-methylcyclohexane carboxylate, ethylene glycol-bis(3,4-epoxycyclohexane carboxylate), bis-(3,4-epoxycyclohexylmethyl) adipate, and di-2,3-epoxycyclopentyl ether.
Among compounds with an oxetane ring, conceivable examples include a compound with one oxetane ring such as 3-ethyl-3-hydroxymethyloxetane, 3-ethyl-3-(phenoxymethyl)oxetane, 3,3-diethyloxetane, and 3-ethyl-3-(2-ethylhexyloxymethyl)oxetane; and a compound with two or more oxetane rings such as 1,4-bis{[(3-ethyl-3-oxetanyl)methoxy]methyl}benzene, di(1-ethyl(3-oxetanyl))methyl ether, and pentaerythritoltetrakis(3-ethyl-3-oxetanylmethyl) ether.

### (b) Photopolymerization initiator

A photopolymerization initiator in the present invention is not particularly limited, provided that it is a compound with a function capable of initiating polymerization of the polymerizable compound by pattern exposure.
The method of pattern exposure may be photomask exposure, phase mask exposure, interference exposure and the like. Among the aforementioned, the interference exposure method is preferable.
The light source of interference exposure is generally laser light with high coherence and high sensitivity to the photopolymerization initiator. For example, lasers such as an argon ion laser (458 nm, 488 nm, 514.5 nm), krypton ion laser (647.1 nm), Nd:YAG laser (532 nm), Nd:YVO₄ laser (532 nm), and InGaN laser (405 nm) are used.
If the polymerizable compound is a compound with an ethylenically unsaturated bond, then the photopolymerization initiator is preferably a photoradical polymerization initiator that generates active radicals during pattern exposure.
If a compound with a vinyl ether structure, an epoxy ring, or an oxetane ring having as the cationic polymerizable region is used as the polymerizable compound, then the photopolymerization initiator is preferably a photoacid generator that generates Lewis acid or Brönsted acid during interference exposure.
The photoradical polymerization initiator is not particularly limited, provided that it is a compound that generates active radicals during pattern exposure. The following, for example, may be used: an azo-based compound, an azide-based compound, a diazo-based compound, an o-quinone diazide-based compound, an organic peroxide, benzophenones, biscoumarin, a bisimidazole compound, a titanocene compound, an organic thiol compound, a halogenated hydrocarbon compound, a trichloromethyl triazine compound, and an onium salt compound such as an iodonium salt compound and a sulfonium salt compound. Among the aforementioned, the titanocene compound is preferable.
The photoradical polymerization initiator may be used alone or in combination as necessary.
The titanocene compound is not particularly limited, however, specific examples include dicyclopentadienyl-titanium-dichloride, dicyclopentadienyl-titanium-bisphenyl, dicyclopentadienyl-titanium-bis(2,3,4,5,6-pentafluorophenyl), dicyclopentadienyl-titanium-bis(2,3,5,6-tetrafluorophenyl), dicyclopentadienyl-titanium-bis(2,4,6-trifluorophenyl), dicyclopentadienyl-titanium-bis(2,6-difluorophenyl), dicyclopentadienyl-titanium-bis(2,4-difluorophenyl), bis(methylcyclopentadienyl)-titanium-bis(2,3,4,5,6-pentafluorophenyl), bis(methylcyclopentadienyl)-titanium-bis(2,3,5,6-tetrafluorophenyl), bis(methylcyclopentadienyl)-titanium-bis(2,6-difluorophenyl), and dicyclopentadienyl-titanium-bis(2,6-difluoro-3-(1H-pyrrole-1-yl)-phenyl).
Among azide-based compounds, conceivable examples include p-azido benzaldehyde, p-azido acetophenone, p-azido benzoic acid, p-azido benzalacetophenone, 4,4'-diazide chalcone, 4,4'-diazide diphenyl sulfide, 2,6-bis(4'-azidobenzal)-4-methylcyclohexanone, and α-cyano-4,4'-dibenzo-stilbene.
Among azo-based compounds, conceivable examples include 1,2-naphthoquinone-diazide(2)-4-sulfonic acid sodium salt, 1,2-naphthoquinonediazide(2)-5-sulfonic acid ester, and 1,2-naphthoquinone-diazide(2)-4-sulfonyl chloride.
Among diazo-based compounds, conceivable examples include 1-diazo-2,5-diethoxy-4-p-tolylmercaptobenzene borofluoride, 1-diazo-4-N,N-dicethylaminobenzene chloride, and 1-diazo-4-N,N-diethylaminobenzene borofluoride.
Among o-quinone diazide-based compounds, conceivable examples include 1,2-naphthoquinone-diazide(2)-4-sulfonic acid sodium salt, 1,2-naphthoquinonediazide(2)-5-sulfonic acid ester, and 1,2-naphthoquinone-diazide(2)-4-sulfonyl chloride.
Among benzophenones, conceivable examples include benzophenone, 4,4'-bisdiethylaminobenzophenone, 1,4-dibenzoylbenzene, 10-butyl-2-chloroacridone, 2-benzoylnaphthalene, 4-benzoylbiphenyl, 4-benzoyldiphenyl ether, and benzil.
Biscoumarin may be, for example, 3,3'-carbonylbis(7-(diethylamino)-2H-chromene-2-one. This is sold by Midori Kagaku Co., Ltd. as BC(CAS[63226-13-1]).
Among bisimidazole compounds, conceivable examples include 2,2'-bis(o-chlorophenyl)-4,5,4',5'-tetrakis(3,4,5-trimethoxyphenyl)-1,2'-bisimidazole, and 2,2'-bis(o-chlorophenyl)-4,5,4',5'-tetraphenyl-1,2'-bisimidazole.
The photoacid generator is not particularly limited, provided that it is a compound that generates Lewis acid or Brönsted acid during interference exposure. Conceivable examples include an onium salt compound such as a diallyliodonium salt compound, a triarylsulfonate compound, and a diazonium salt compound; and an iron arene complex compound.
Among diallyliodonium salt compounds, conceivable examples include iodonium salts of tetrafluoroborate, hexafluorophosphate, hexafluoroarsenate, and hexafluoroantimonate, in which iodoniums include diphenyliodonium, 4,4'-dichlorodiphenyliodonium, 4,4'-dimethoxydiphenyliodonium, 4,4'-di-tertiarybutyldiphenyliodonium, (4-methylphenyl)[4-(2-methylpropyl)phenyl]iodonium, and 3,3'-dinitrophenyliodonium.
Among triarylsulfonate compounds, conceivable examples include sulfonium salts of tetrafluoroborate, hexafluorophosphate, hexafluoroarsenate, and hexafluoroantimonate, in which sulfoniums include triphenylsulfonium, 4-tertiarybutyltriphenylsulfonium, tris(4-methylphenyl)sulfonium, tris(4-methoxyphenyl)sulfonium, and 4-thiophenyltriphenylsulfonium.
Among iron arene complex compounds, conceivable examples include, biscyclopentadienyl-(η6-isopropylbenzene)-iron(II)hexafluorophosphate.
The photoacid generator may be used alone or in combination as necessary.
For the photosensitive composition of the present invention, a photoradical polymerization initiator is generally used as the photopolymerization initiator if a compound with an ethylenically unsaturated bond, i.e., a radical polymerizable region, is used as the polymerizable compound. Meanwhile, a photoacid generator is generally used as the photopolymerization initiator if a compound with a vinyl ether structure, an epoxy ring, or an oxetane ring, i.e., a cationic polymerizable region, is used as the polymerizable compound.

### (c) Organic fine particles

The organic fine particles are not particularly limited, provided that they are structured by an organic compound capable of achieving the object of the present invention. However, due to the need to reduce light scattering loss, organic fine particles with an average particle size of 100 nm or less is preferable. The average particle size of the organic fine particles is, for example, 1 nm to 100 nm, 2 nm to 50 nm, or 3 nm to 30 nm.
The average particle size (nm) of the organic fine particles can be measured by a transmission electron microscope. Also, the molecular weight distribution of the organic fine particles can be measured by gel permeation chromatography.
Specific examples of the organic fine particles include, for example, hyperbranched polymers, dendrimers, starburst polymers, fullerene, and nano-diamonds. The organic fine particles are preferably macromolecules whose main chains have a high degree of branching, such as hyperbranched polymers, dendrimers, and starburst polymers. Among the aforementioned, hyperbranched polymers are particularly preferable in terms of dispersibility, transparency, and economy.
A main chain with a high degree of branching results in less interaction with the resin component. Therefore, the molecules act like particles and easily move within the resin, thereby enabling large movement upon light irradiation. As a consequence, the difference between the refractive indices of light and dark portions grows, and subsequently enables diffraction grating (data recording).
The hyperbranched polymer is generally a macromolecule with a high degree of branching. The hyperbranched polymer is achieved through condensation or addition polymerization, or insertion reaction of an ABx type compound such as AB2 or AB3, which has one functional group A within a monomolecule and two or more functional groups B capable of reacting with the functional group A, or a compound known as an AB* type, which respectively combines one of a polymerization point and an initiator.
With an AB* type molecule, the functional group A acting as the polymerization point reacts with the functional group B* acting as the initiator. The functional group A disappears post-reaction; however, B* remains intact to become a compound with B* reactivity even after the reaction due to elimination or addition polymerization.
Here, in the case of an AB2 type molecule, for example, the functional group A may be a carboxyl group, in which case the functional group B is an amino group. The AB2 type molecule would thus be hyperbranched polyamide. In the case of an AB* type molecule, the functional group A may be a styrenic double bond, in which case the function group B* is a dithiocarbamate group. The AB* type molecule would thus be hyperbranched polystyrene.
Conceivable structural examples of hyperbranched polymers include, for example: a polyphenylene structure, a polyester structure, a polycarbonate structure, a polyether structure, a polythioether structure, a polyetherketone structure, a polyethersulfone structure, a polyamide structure, a polyetheramide structure, a polyamidoamine structure, a polyurethane structure, a polyurea structure, a polysiloxysilane structure, a polycarbosilane structure, a polyethynylene structure, a polyphenylenevinylene structure, a polyaniline structure, a polyacrylate structure, a polymethacrylate structure, a polystyrene structure, and a polyamine structure described in Dendorima no Kagaku to Kinou (Japanese) [The Science and Function of Dendrimers (English)]. Okada, Masahiko eds. IPC, 2000, p. 79-116.
Conceivable structural examples of dendrimers include, for example, structures described in Dendrimers and Dendrons. Newkome, G. R. et al. eds Willy-VCH 2001 and a polybenzylether dendrimer structure based on the repetition of a dioxybenzyl group, such as the 3,5-dioxybenzyl group, which is an example reported by C. J. Hawker, et al. in J. Am. Chem. Soc. 1990, vol. 112, p. 7638-7647. Other structural examples are polyetherketone dendrimer structures based on various repetitions, such as the examples reported by A. Morikawa, et al. in Macromolecules 1993, vol. 26, p. 6324-6329; T. M. Miller, et al. in J. Am. Chem. Soc. 1993, vol. 15, p. 356-357; C. J. Hawker, et al. in Macromolecules 1996, vol. 29, p. 4370-4380; A. Morikawa, et al. in Macromolecules , vol. 31, p., 5999-6009; A. Morikawa, et al. in Macromolecules 1999, vol. 32, p. 1062-1068; A. Morikawa, et al. in Polymer Journal 2000, vol. 32, p. 234-242; and A. Morikawa, et al. in Polymer Journal 2000, vol. 32, p. 255-262. Yet other structural examples include a polyamidoamine dendrimer structure reported by D. A. Tomalia, et al. in Angew. Chem. Int. Ed. Engl. 1990, vol. 29, p. 138-175; a polypropyleneimine dendrimer structure, which is an example reported by E. M. M. de Brabander-van den Berg, et al. in Angew. Chem. Int. Ed. Engl. 1993, vol. 32, p. 1308; an aliphatic polyether dendrimer structure, which is an example reported by M. Jayaraman, et al. in J. Am. Chem. Soc. 1998, vol. 120, p. 12996-12997; and an aliphatic polyester dendrimer reported by H. Ihre, et al. in Macromolecules 1998, vol. 31, p. 4061-4068.
Conceivable structural examples of starburst polymers include, for example, star polymer structures such as star polybutadiene, a poly(styrene-block-isoprene)star block copolymer structure, a (polystyrene-star-polyisoprene-star-polybutadiene)star block copolymer structure, and a (polystyrene-star-polyisoprene-star-polymethylmethacrylate)star block copolymer structure described in Bunki Porima no Nanotekunoroji (Japanese) [The Nanotechnology of Branched Polymers (English)]. Ishizu, Koji eds. IPC, 2000, p. 27-49.

The pattern of the hologram or the like records a light interference pattern based on a difference between the refractive indices of at least two different types of components included in a recording layer.
Therefore, in the present invention, under the condition of pattern exposure for forming a pattern, e.g. under the condition of interference exposure for recording a hologram, a difference is required between the refractive index of the polymers generated by the above polymerizable compounds and the refractive index of the organic fine particles. For example, multiple recording of multiple pattern exposure information on one hologram requires a large dynamic range for recording, and therefore, the difference between the refractive indices of the polymer and the organic fine particles must be 0.001 to 1.0, or 0.01 to 1.0.
For example, the difference between a refractive index of organic fine particles with respect to a light wavelength used in interference exposure for a hologram recording, and a refractive index of polymers with respect to a light wavelength used in interference exposure for a hologram recording, which are generated under the condition of interference exposure by a polymerizable compound, is required to be 0.001 to 1.0, 0.01 to 1.0, 0.02 to 0.50, or 0.03 to 0.15. The organic fine particles and polymerizable compound are thus selected based on such considerations.
As the polymerizable compound, it is preferable to use a compound that gives polymers with a refractive index of 1.3 to 2.0, or 1.4 to 1.8, with respect to a light wavelength used in interference exposure for hologram recording. For example, it is preferable to use a compound that gives polymers with a refractive index of 1.3 to 2.0, or 1.4 to 1.8, with respect to 589-nm light wavelength.
The polymer refractive index can be found as follows. A composition formed from the polymerizable compound and the photopolymerization initiator is coated on a support and undergoes drying as needed. A polymer is obtained through exposure under the condition of light used in interference exposure for hologram recording, and the refractive index of the polymer is measured. Based on the refractive index of the polymer obtained in such a manner and the refractive index of the organic fine particles, it is possible to select the polymerizable compound and the organic fine particles for the hologram recording material composition of the present invention.

In the photosensitive composition of the present invention, additives such as a polymerization inhibitor, a sensitizer, a chain transfer agent, an elasticizer, a colorant may be included as necessary in addition to the above components (a) to (c). Also, a binder resin may be included that acts as a binding material to achieve a uniform film thickness and stabilize a hologram formed by polymerization from light irradiation.

A polymerization inhibitor in general is a compound that delays or inhibits polymerization, and is not particularly limited in the present invention. In the case of radical polymerization, the following are conceivable: phenol, catechol, benzoquinone, hydroquinone, and their esters and ethers; hindered phenols obtained from alkylation; phenothiazine; hindered amines; hydroxyamines such as TEMPO; and nitrosamines. In the case of cationic polymerization, a compound exhibiting basicity is conceivable, particularly organic amines.

The photoradical polymerization initiator according to the present invention may be used alone, or in combination with a sensitizer that is a light-absorbing component.
Preferable sensitizers include, for example: pyrromethene complexes such as a 2,6-diethyl-1,3,5,7,8-pentamethylpyrromethene-BF₂ complex and a 1,3,5,7,8-pentamethylpyrromethene-BF₂ complex; xanthene-based dyes such as eosin, ethyleosin, erythrocin, fluorescein, and rose bengal; ketothiazoline-based compounds such as 1-(1-methylnapth[1,2-d]thiazole-2(1H)-ylidene-4-(2,3,6,7)tetrahydro-1H,5H-benzo[ij]quinolizine-9-yl)-3-butene-2-one, and 1-(3-methylbenzothiazole-2(3H)-ylidene-4-(p-dimethylaminophenyl)-3-butene-2-one; styryl or phenylbutadienyl heterocyclic compounds such as 2-(p-dimethylaminostyryl)-napth[1,2-d]thiazole, and 2-[4-(p-dimethylaminophenyl)-1,3-butadienyl-napth[1,2-d]thiazole; nanthryl-(([2,3,6,7]tetrahydro-1H,5H-benzo[ij]quinolizine-9-yl)-1-ethene-2-yl)ketone such as 2,4-diphenyl-6-(p-dimethylaminostyryl)-1,3,5-triazine, and 2,4-diphenyl-6-(([2,3,6,7]tetrahydro-1H,5H-benzo[ij]quinolizine-9-yl)-1-ethene-2-yl)-1,3,5-triazone; aminophenyl unsaturated ketone compounds such as 2,5-bis(p-dimethylaminocinnamylidene)cyclopentanone; and porphyrins such as 5,10,15,20-tetraphenylporphyrin, and hemaporphyrin. Among the aforementioned, the pyrromethene complexes are particularly preferable, and a cyanine-based dye is preferable for applications requiring colorless transparency under visible light.
In cases where the photoradical polymerization initiator is a titanocene compound, it is preferable to use benzophenones, biscoumarin, a bisimidazole compound, or a pyrromethene compound as the sensitizer.
By using a hydrogen donor, e.g. thiols, alkylamines and amino acids, further supersensitization can also be achieved. Conceivable examples of thiols include 2-benzoxazole thiol and 2-benzothiazole thiol. Conceivable examples of amino acids include N-phenylglycine and 4-cyano-N-phenylglycine.

A photocationic polymerization initiator according to the present invention may be used alone, or in combination with a sensitizer that is a light-absorbing component. Examples of sensitizers usable in the present invention include carbazole derivatives, such as carbazole, N-ethylcarbazole, N-vinylcarbazole, and N-phenylcarbazole; naphthalene derivatives such as 1-naphthol, 2-naphthol, 1-methoxynaphthalene, 1-stearyloxynaphthalene, 2-methoxynaphthalene, 2-dodecyloxynaphthalene, 4-methoxy-1-naphthol, glycidyl-1-naphthyl ether, 2-(2-naphthoxy)ethyl vinyl ether, 1,4-dihydroxynaphthalene, 1,5-dihydroxynaphthalene, 1,6-dihydroxynaphthalene, 2,7-dihydroxynaphthalene, 2,7-dimethoxynaphthalene, 1,1'-thiobis(2-naphthol), 1,1'-bi-2-naphthol, 1,5-naphthyldiglycidyl ether, 2,7-di(2-vinyloxyethyl)naphthyl ether, 4-methoxy-1-naphthol, and a condensate of a naphthol derivative and formalin; anthracene derivatives, such as 9,10-dimethoxyanthracene, 2-ethyl-9,10-dimethoxyanthracene, 2-tert-butyl-9,10-dimethoxyanthracene, 2,3-dimethyl-9,10-dimethoxyanthracene, 9-methoxy-10-methylanthracene, 9,10-diethoxyanthracene, 2-ethyl-9,10-diethoxyanthracene, 2-tert-butyl-9,10-diethoxyanthracene, 2,3-dimethyl-9,10-diethoxyanthracene, 9-ethoxy-10-methylanthracene, 9,10-dipropoxyanthracene, 2-ethyl-9,10-dipropoxyanthracene, 2-tert-butyl-9,10-dipropoxyanthracene, 2,3-dimethyl-9,10-dipropoxyanthracene, 9-isopropoxy-10-methylanthracene, 9,10-dibenzyloxyanthracene, 2-ethyl-9,10-dibenzyloxyanthracene, 2-tert-butyl-9,10-dibenzyloxyanthracene, 2,3-dimethyl-9,10-dibenzyloxyanthracene, 9-benzyloxy-10-methylanthracene, 9,10-di-α-methylbenzyloxyanthracene, 2-ethyl-9,10-di-α-methylbenzyloxyanthracene, 2-tert-butyl-9,10-di-α-methylbenzyloxyanthracene, 2,3-dimethyl-9,10-di-α-methylbenzyloxyanthracene, 9-(α-methylbenzyloxy)-10-methylanthracene, 9,10-di(2-hydroxyethoxy)anthracene, and 2-ethyl-9,10-di(2-carboxyethoxy)anthracene; chrysene derivatives, such as 1,4-dimethoxychrysene, 1,4-diethoxychrysene, 1,4-dipropoxychrysene, 1,4-dibenzyloxychrysene, and 1,4-di-α-methylbenzyloxychrysene; and phenanthrene derivatives, such as 9-hydroxyphenanthrene, 9,10-dimethoxyphenanthrene, and 9,10-diethoxyphenanthrene. Among the aforementioned derivatives, it is preferable to use 9,10-dialkoxyanthracene derivatives being optionally-substituted with an alkyl group which particularly contains 1 to 4 carbon atoms, and it is further preferable if an alkoxy group contained therein is either a methoxy group or an ethoxy group.
Among thioxanthone derivatives, conceivable examples include thioxanthone, 2,4-dimethylthioxanthone, 2,4-diethylthioxanthone, isopropylthioxanthone, and 2-chlorothioxanthone.

The above radical initiators, e.g. a titanocene compound such as dicyclopentadienyl-titanium, are also known to act as a sensitizer for photoacid generators. In such case, these radical initiators can be used in combination with a photoacid generator and a radical polymerization initiator, or in a combination with a photoacid generator, a radical polymerization initiator, and a sensitizer of the radical polymerization initiator.

The amount of sensitizer must be increased or decreased depending on the thickness of the medium used; however, with respect to the polymerization initiator, the mass ratio is 0.01% to 10%, and preferably 0.1% to 5%.

The binder resin preferably has good compatibility with the polymerizable compound, and specific examples conceivably include a copolymer of chlorinated polyethylene, polymethylmethacrylate, methylmethacrylate, and other alkyl(meth)acrylate esters; a copolymer of vinyl chloride and acrylonitrile; polyvinyl acetate; polyvinyl alcohol, polyvinyl formal; polyvinyl butyral; polyvinyl pyrrolidone; polyvinyl carbazole; ethyl cellulose; and acetyl cellulose.

To form a pattern using the photosensitive composition of the present invention, first, the composition is coated on an appropriate support such as a resin film, by which a coating film is formed. Next, the coating film undergoes pattern exposure. The pattern exposure is not particularly limited, provided that it is an exposure method capable of forming a pattern. The pattern exposure may be interference exposure, for example, or the pattern exposure may be a method in which exposure is performed through an appropriate mask (photomask exposure, phase mask exposure, and the like).

The photosensitive composition of the present invention includes a polymerizable compound, a polymerization initiator, and organic fine particles. Therefore, exposure performed through a mask, for example, triggers a polymerization reaction in the polymerizable compound, whereby polymers are formed in the exposed portion. As a consequence, the chemical potential of the exposed portions on the polymerizable compound decreases, but is compensated by movement in the polymerizable compound from the non-exposed portion to the exposed portion. Meanwhile, a decrease in the polymerizable compound on the exposed portion is accompanied by an increase in the chemical potential of organic fine particles that do not participate in the photopolymerization. To suppress this increase, the organic fine particles thus move from the exposed portion to the non-exposed portion. Such movement of each component essentially continues until photopolymerization is complete. The spatial distribution of the organic fine particles is consequently fixed, and a pattern is formed according to the difference between the components in the exposed and non-exposed portions, and the density of the components. In other words, the pattern formed by the photosensitive composition of the present invention utilizes the difference between the spatial distribution of components, which resulted from the interdiffusion of components within the composition due to pattern exposure.

To create a hologram recording layer using the photosensitive composition of the present invention, first, the polymerizable compound, the photopolymerization initiator, and the organic fine particles are mixed together with additives, such as a sensitizer and a binder resin, as necessary and then the mixture is coated on a support, or alternatively, a solvent is added and mixed to the mixture, which is then coated on the support and dried as necessary, whereby a hologram recording layer is formed on the support to obtain a hologram recording medium. Furthermore, the hologram recording medium can also be achieved by covering the top of the hologram recording layer with a protective material. The thickness of the hologram recording layer may be, for example, 1 to 1000 µm, 30 to 500 µm, or 50 to 200 µm.

Conceivable solvents include, for example, acetone, methylethylketone, methylisobutylketone, cyclohexanone, toluene, xylene, tetrahydrofuran, methyl cellosolve, ethyl cellosolve, methyl cellosolve acetate, ethyl acetate, 1,4-dioxane, 1,2-dichloroethane, dichloromethane, chloroform, methanol, ethanol, and isopropanol. A combined solvent of any of the aforementioned may also be used. The mass of the solvent used may be 0.5 to 20 times the total mass of the components (a) to (c).

For the support, a transparent glass plate, an acrylic plate or the like may be used. In addition, a transparent resin film such as a polyethylene telephthalate film and a polyethylene film may also be used for the support.
Methods that may be used for coating the photosensitive composition of the present invention on the support include a direct drop method, as well as conventional known methods such as spin coating, wire-bar coating, dip coating, air knife coating, roll coating, blade coating, and curtain coating.

For the protective material, a known material that protects against adverse affects such as a deterioration in preservation stability or reduced sensitivity due to oxidation may be used. Conceivable examples include a transparent resin film such as a polyethylene telephthalate film and a polyethylene film. A resin film formed by a coating of water-soluble polymers or the like may also be used.

The photosensitive composition of the present invention includes organic fine particles and a polymerizable compound. The organic fine particles are diffused among the polymerizable compound in the hologram recording layer obtained from the composition. As a consequence, there is a large difference between the refractive indices of the region corresponding to the light portion and the region corresponding to the dark portion of the interference fringe. Thus, the recording layer obtained from the composition is a hologram recording layer capable of forming a hologram with high diffraction efficiency.

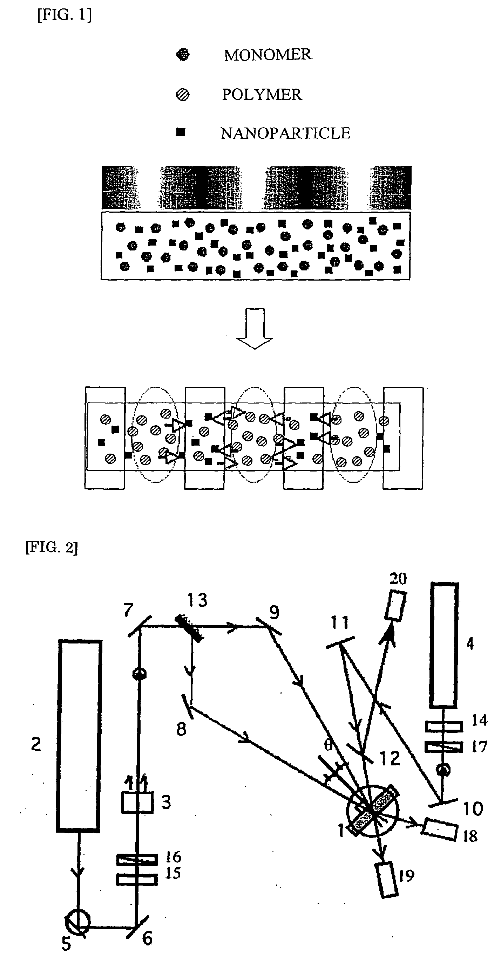

Next, a hologram recording method that uses the hologram recording layer of the present invention will be explained using FIG. 1. First, a hologram recording medium with the hologram recording layer of the present invention is simultaneously irradiated by two mutually coherent laser beams, such that an interference fringe (a pattern with cyclic shading in the figure) is formed in which light portions and dark portions are aligned in a striped configuration on the hologram recording layer. In the case of such spatially uneven light irradiation, as more of the polymerizable compound (monomers) are consumed and become polymers in the light portion, the chemical potential of the polymerizable compound decreases. This results in movement (diffusion) of the polymerizable compound from the dark portion to the light portion to compensate. Meanwhile, a decrease in the polymerizable compound in the light portion is accompanied by an increase in the chemical potential of organic fine particles that do not participate in the photopolymerization. To suppress this increase, the organic fine particles thus reversely diffuse from the light portion to the dark portion. Such an interdiffusion process essentially continues until photopolymerization is complete. The spatial distribution of the organic fine particles is consequently fixed. Due to the differences of the composition and the density in the light and dark portions, a refractive-index grating (a hologram) is formed and the hologram is recorded. At reproduction, the irradiation of reproduced light on the region where the hologram is formed results in diffraction that reproduces a holographic image.
The refractive-index modulation of a volume phase type hologram is basically determined by a sum of the products of the refractive indices and the volume ratios of structural components. Hence, the movement of the polymerizable compound and the organic fine particles is an important element for increasing the refractive-index modulation. However, only so many organic fine particles can diffuse within the composition at one time, and diffusion becomes difficult if there are too many organic fine particles. Diffusion is also difficult if there are too few organic fine particles, making it impossible to increase the steady refractive-index modulation.
Therefore, in the photosensitive composition of the present invention, it is preferable that the mass percentage of the organic fine particles with respect to the total mass of the aforementioned (a) polymerizable compound, (b) photopolymerization initiator, and (c) organic fine particles is, for example, 3 mass% to 60 mass%, 10 mass% to 50 mass%, or 20 mass% to 40 mass%. Also, the ratio of polymerizable compound with respect to the total mass of the polymerizable compound, photopolymerization initiator, and organic fine particles is, for example, 35 mass% to 92 mass%, 47 mass% to 87 mass%, or 58 mass% to 78 mass%. The ratio of photopolymerization initiator is, for example, 0.01 mass% to 5 mass%, 0.1 mass% to 3 mass%, or 0.5 mass% to 2 mass%.
If the photosensitive composition of the present invention contains other components (excluding solvents) besides the components (a) to (c), then the content used may be a mass that is 0.0001 to 1 time, or a mass that is 0.01 to 0.5 time, the total mass of the components (a) to (c).

Next, the present invention will be explained in more specific detail using examples.

### Examples

### Example 1

### Preparation of Photosensitive Composition

A photosensitive composition was prepared as follows. First, 0.1 g of organic fine particles, namely, hyperbranched polymers according to formula (1) (Nissan Chemical Industries, Ltd., trade name: OPTBEADS HPS-H) was dissolved in 0.253 g of toluene. Next, 0.212g of a polymerizable compound, namely, tricyclodecane dimethanol dimethacrylate (Shin-Nakamura Chemical Co., Ltd., trade name: NK ESTER DCP) was added and homogeneously dispersed throughout. Then, 0.002 g of a photopolymerization initiator, namely, dicyclopentadienyl-titanium-bis(2,6-difluoro-3-(1H-pyrrol-1-yl)-phenyl) (Ciba Specialty Chemicals Inc., trade name: IRGACURE 784) was subsequently dissolved. 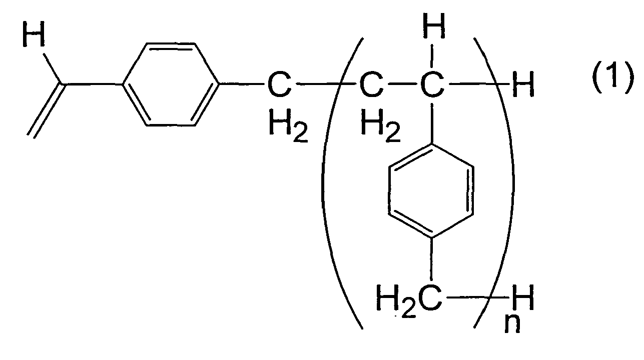 A weight-average molecular weight Mw of 38,900 was measured for the hyperbranched polymer according to formula (1) by gel permeation chromatography relative to polystyrene standards, and the dispersity index Mw/Mn was 4.8.
The refractive index of the hyperbranched polymer of formula (1) with respect to a 589-nm light wavelength is 1.61, and the refractive index of the polymer obtained from tricyclodecane dimethanol dimethacrylate is 1.53, thus achieving a difference of 0.08 between the two refractive indices.
Measurement of the refractive index of the polymer obtained from tricyclodecane dimethanol dimethacrylate was performed as follows.
Polyethylenetelephthalate films with a 50 µm thickness were applied to both ends of a slide glass to serve as spacers. The composition formed by dissolving IRGACURE 784 at 1 mass% in tricyclodecane dimethanol dimethacrylate was dropped onto the center portion (an area between the spacers) of the slide glass. Next, the slide glass was covered and fixed, and evenly exposed for five minutes to an Nd:YVO₄ laser with a 532-nm wavelength at an exposure power density of 100 mW/cm². The obtained film was then peeled from the slide glass and measured using an Abbe refractometer (Atago, DR-M4 model, 589-nm interference filter).
The density of the hyberbranched polymer of formula (1) is 1.05 g/cm³ and therefore the volume is 0.101/1.05=0.0962 cm³. The density of the polymer obtained from tricyclodecane dimethanol dimethacrylate is 1.16 g/cm³ and therefore the volume is 0.212/1.16=0.183 cm³. Accordingly, the ratio of hyperbranched polymers to the volume of the polymerized hyperbranched polymers and tricyclodecane dimethanol dimethacrylate is 0.0962/(0.0962+0.183)=0.34, that is, 34 volume%.

### Measurement of Diffraction Efficiency

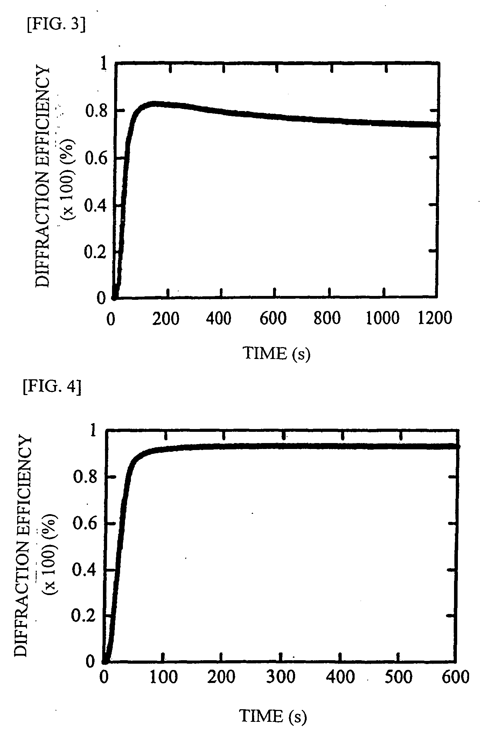

Polyethylenetelephthalate films with a 50 µm thickness were applied to both ends of a slide glass to serve as spacers, and the photosensitive composition was dropped onto the center portion (an area between the spacers) of the slide glass. This was dried in an oven for approximately 25 minutes at 80°C, forming hologram recording layer. Thereafter, the slide glass was covered to produce a volume phase type hologram recording medium with a thickness of approximately 51 µm.
Two-beam interference exposure was performed using an apparatus shown in FIG. 2, to attempt to record a volume hologram on the recording medium. Using an Nd:YVO₄ laser with a 532-nm wavelength, two-beam interference exposure (grating space: 1 µm) was performed at an exposure power density of 100 mW/cm² on the hologram recording medium. Light irradiated from the Nd:YVO₄ laser passes through a beam expander and is divided into two by a half mirror. The two resulting beams are respectively reflected off mirrors and irradiate the hologram recording medium, whereby the interference fringe from the two beams is recorded to form a hologram.
At the same time, the hologram formation process was monitored and the diffraction efficiency evaluated. This was achieved by irradiating a helium-neon (He-Ne) laser with a 632.8-nm wavelength onto the hologram recording medium (which was not sensitized to such light) and detecting the diffracted light using a light detection unit. FIG. 3 shows a graph indicating the changes over time in the diffraction efficiency of the sample. The diffraction efficiency increases sharply, reaching 80% at approximately 20 seconds, and high diffraction efficiency is maintained thereafter. In other words, it was confirmed that a permanent volume phase type hologram with near 100% diffraction efficiency can be formed.

### Example 2

### Preparation of Photosensitive Composition

A photosensitive composition was prepared as follows. First, 0.1 g of organic fine particles, namely, hyperbranched polymers according to formula (2) (Nissan Chemical Industries, Ltd., trade name: OPTBEADS HPEMA-H) was dissolved in 0.253 g of toluene. Next, 0.196 g of a polymerizable compound, namely, p-bis(β-methacryloyloxyethylthio)xylylene was added and homogeneously dispersed throughout. Then, 0.0022 g of a photopolymerization initiator, namely, dicyclopentadienyl-titanium-bis(2,6-difluoro-3-(1H-pyrrol-1-yl)-phenyl) (Ciba Specialty Chemicals Inc., trade name: IRGACURE 784,) was subsequently dissolved. 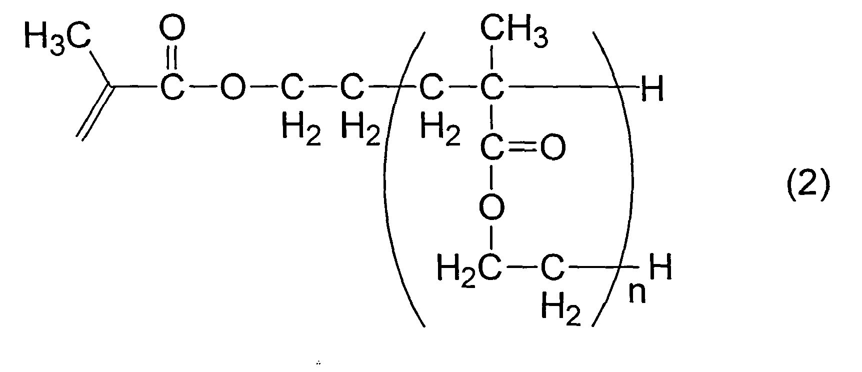 A weight-average molecular weight Mw of 36,100 was measured for the hyperbranched polymer according to formula (2) by gel permeation chromatography relative to polystyrene standards, and the dispersity index Mw/Mn was 2.2.
The refractive index of the hyperbranched polymer of formula (2) with respect to a 589-nm light wavelength is 1.51, and the refractive index of the polymer obtained from p-bis(β-methacryloyloxyethylthio)xylylene is 1.59, thus achieving a difference of 0.08 between the two refractive indices.
Measurement of the refractive index of the polymer obtained from p-bis(β-methacryloyloxyethylthio)xylylene was performed in the same manner as for Example 1.
The density of the hyberbranched polymer of formula (2) is 1.17 g/cm³ and therefore the volume is 0.1006/1.17=0.0846 cm³. The density of the polymer obtained from p-bis(β-methacryloyloxyethylthio)xylylene is 1.25 g/cm³ and therefore the volume is 0.196/1.25=0.1568 cm³. Accordingly, the ratio of hyperbranched polymers to the volume of the polymerized hyperbranched polymers and p-bis(β-methacryloyloxyethylthio)xylylene is 0.0846/(0.0846+0.1568)=0.35, that is, 35 volume%.

### Measurement of Diffraction Efficiency

A volume phase type hologram recording medium with a thickness of approximately 31 µm was produced according to the same method as used in Example 1.
The diffraction efficiency was also measured according to the same method as used in Example 1. FIG. 4 shows a graph indicating the changes over time in the diffraction efficiency of the sample.

### Example 3

### Observation by Transmission Electron Microscope

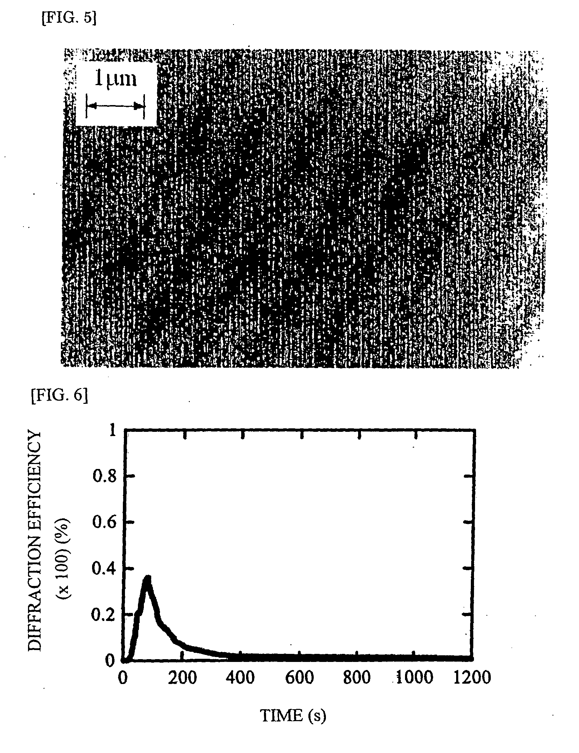

A photosensitive composition was prepared according to the same method as used in Example 1. Hyperbranched polymers (Nissan Chemical Industries, Ltd., trade name: OPTBEADS HPS-H, weight-average molecular weight Mw: 38,900 and diffusion degree Mw/Mn: 4.9 as measured relative to polystyrene standards) were dispersed into a polymerizable compound, namely, p-bis(β-methacryloyloxyethylthio)xylylene, after which a photopolymerization initiator, namely, dicyclopentadienyl-titanium-bis(2,6-difluoro-3-(1H-pyrrol-1-yl)-phenyl) (Ciba Specialty Chemicals Inc., trade name: IRGACURE 784) was added to obtain a photosensitive composition with 34 volume% of HPS-H. A volume phase type hologram recording medium was then produced from the composition using the same method as in Example 1, and a volume phase hologram was created according to the same method as in Example 1.
The obtained film was directly cut into thin sections with thicknesses on the level of several tens of nanometers by a microtome in the in-plane direction. Following dying with ruthenium tetraoxide (RuO₄), the film was observed using a transmission electron microscope (Hitachi, H8000). The results are shown in FIG. 5. Black dots in the figure indicate HPS-H particles, and it was confirmed that the HPS-H particles are periodically arrayed in a purely optical manner by holographic exposure.

### Example 4

### Preparation of Photosensitive Composition

A photosensitive composition was prepared as follows. First, 0.5 g of organic fine particles, namely, hyperbranched polymers according to formula (1) (Nissan Chemical Industries, Ltd., trade name: OPTBEADS HPS-H, weight-average molecular weight Mw: 19,700 and diffusion degree Mw/Mn: 3.3 as measured relative to polystyrene standards) was dissolved in 2.0 g of tetrahydrofuran. Next, polymerizable compounds were added and homogeneously dispersed throughout, namely, 0.1 g of 3,4-epoxycyclohexylmethyl-3',4'-epoxycyclohexane carboxylate (Daicel Chemical Industries, Ltd., trade name: CELLOXIDE 2021 P) and 0.9 g of 1,4-bis{[(3-ethyl-3-oxetanyl)methoxy]methyl}benzene (Toagosei Co., Ltd., trade name: OXT-121). Then, photopolymerization initiators were subsequently dissolved, namely, 0.25 g of dicyclopentadienyl-titanium-bis(2,6-difluoro-3-(1H-pyrrol-1-yl)-phenyl) (Ciba Specialty Chemicals Inc., trade name: IRGACURE 784) and 0.05 g of hexafluorophosphate from (4-methylphenyl)[4-(2-methylpropyl)phenyl]) (Ciba Specialty Chemicals Inc., trade name: IRGACURE 250).
A volume phase type hologram recording medium with a thickness of approximately 78 µm was produced according to the same method as used in Examples 1 and 2. Moreover, after measuring the diffraction efficiency according to the same method as used in Examples 1 and 2, it was confirmed that a volume phase type hologram with a diffraction efficiency of 66% had been formed.

### Example 5

### Preparation of Photosensitive Composition

A photosensitive composition was prepared as follows. First, 0.5 g of organic fine particles, namely, hyperbranched polymers according to formula (3) (Nissan Chemical Industries, Ltd., trade name: OPTBEADS HPS, weight-average molecular weight Mw: 19,000 and diffusion degree Mw/Mn: 3.9 as measured relative to polystyrene standards) was dissolved in 2.0 g of tetrahydrofuran. Next, polymerizable compounds were added and homogeneously dispersed throughout, namely, 0.1 g of 3,4-epoxycyclohexylmethyl-3',4'-epoxycyclohexane carboxylate (Daicel Chemical Industries, Ltd., trade name: CELLOXIDE 2021 P) and 0.9 g of 1,4-bis{[(3-ethyl-3-oxetanyl)methoxy]methyl}benzene (Toagosei Co., Ltd., trade name: OXT-121). Then, photopolymerization initiators were subsequently dissolved, namely, 0.25 g of dicyclopentadienyl-titanium-bis(2,6-difluoro-3-(1H-pyrrol-1-yl)-phenyl) (Ciba Specialty Chemicals Inc., trade name: IRGACURE 784) and 0.05 g of hexafluorophosphate from (4-methylphenyl)[4-(2-methylpropyl)phenyl]) (Ciba Specialty Chemicals Inc., trade name: IRGACURE 250). 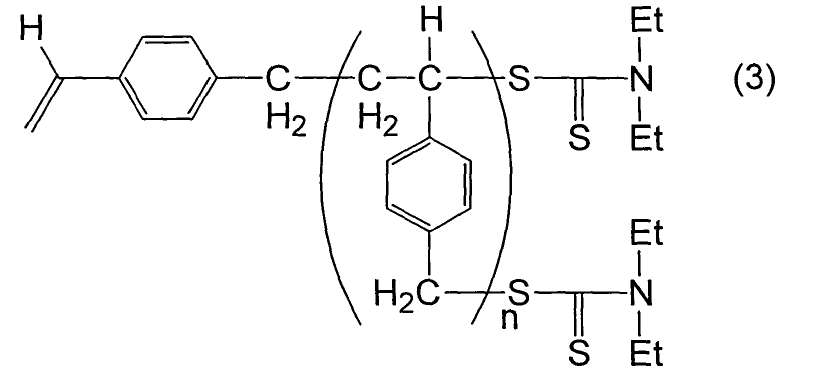 A volume phase type hologram recording medium with a thickness of approximately 55 µm was produced according to the same method as used in Examples 1 and 2. Moreover, after measuring the diffraction efficiency according to the same method as used in Examples 1 and 2, it was confirmed that a volume phase type hologram with a diffraction efficiency of 67% had been formed.

### Example 6

### Preparation of Photosensitive Composition

A photosensitive composition was prepared as follows. First, 0.5 g of organic fine particles, namely, hyperbranched polymers according to formula (1) (Nissan Chemical Industries, Ltd., trade name: OPTBEADS HPS-H, weight-average molecular weight Mw: 38,000 and diffusion degree Mw/Mn: 5.1 as measured relative to polystyrene standards) was dissolved in 2.0 g of tetrahydrofuran. Next, a polymerizable compound, namely, 1.0 g of tricyclodecane dimethanol diacrylate (Shin-Nakamura Chemical Co., Ltd., trade name: NK ESTER A-DCP) was added and homogeneously dispersed throughout. Then, photopolymerization initiators were subsequently dissolved, namely, 0.0 1 g of dicyclopentadienyl-titanium-bis(2,6-difluoro-3-(1H-pyrrol-1-yl)-phenyl) (Ciba Specialty Chemicals Inc., trade name: IRGACURE 784), 0.02 g ofN-phenylglycine (commercial reagent), and 0.005 g of hexaarylbiimidazole (Midori Kagaku Co., Ltd., trade name: BC). A volume phase type hologram recording medium with a thickness of approximately 51 µm was produced according to the same method as used in Examples 1 and 2. Moreover, after measuring the diffraction efficiency according to the same method as used in Examples 1 and 2, it was confirmed that a volume phase type hologram with a diffraction efficiency of approximately 80% had been formed.

### Comparative Example 1

### Measurement of Diffraction Efficiency

An approximately 44-µm thick volume hologram recording medium that contains no organic fine particles was produced in the same manner as Example 1. Similar to Example 1, the medium was subjected to two-beam interference exposure by the device shown in FIG. 2 to record a volume hologram. FIG. 6 shows a graph indicating the changes over time in the diffraction efficiency of the sample. The diffraction efficiency rises at first, but then falls over time to practically disappear in the end. This is due to the polymerizable compound being made of a single component, and corresponds to the loss of refractive-index modulation once the entire compound is polymerized.

## Claims

1. A photosensitive composition, comprising: (a) a polymerizable compound; (b) a photopolymerization initiator; and (c) organic fine particles.

2. The photosensitive composition according to claim 1, wherein the photosensitive composition is used to form a pattern in which movement is generated between components by pattern exposure and a spatial distribution of the components is varied.

3. The photosensitive composition according to claim 1, wherein the photosensitive composition is used to form a spatial refractive-index modulation pattern in which movement is generated between components by pattern exposure and a spatial distribution of the components is varied.

4. The photosensitive composition according to claim 1, wherein the photosensitive composition is used to form a hologram by interference exposure.

5. The photosensitive composition according to claim 1, wherein the polymerizable compound is a compound that gives polymers with a refractive index of 1.3 to 2.0 with respect to an interference exposure wavelength used for hologram recording.

6. The photosensitive composition according to claim 1, wherein a difference between a refractive index of the organic fine particles with respect to an interference exposure wavelength for hologram recording and a refractive index of the polymers with respect to an interference exposure wavelength for hologram recording is not less than 0.001 and not more than 1.0.

7. The photosensitive composition according to claim 1, wherein a difference between a refractive index the organic fine particles with respect to an interference exposure wavelength for hologram recording of and a refractive index of the polymers with respect to an interference exposure wavelength for hologram recording is not less than 0.01 and not more than 1.0.

8. The photosensitive composition according to claim 1, wherein the organic fine particles have an average particle size that is not less than 1 nm and not more than 100 nm.

9. The photosensitive composition according to claim 1, wherein the organic fine particles are hyperbranched polymers, dendrimers, or starburst polymers.

10. The photosensitive composition according to claim 1, wherein the organic fine particles are hyperbranched polymers.

11. The photosensitive composition according to claim 1, wherein a ratio of mass of the organic fine particles to a total mass of the polymerizable compound, the photopolymerization initiator, and the organic fine particles is 3 mass% to 60 mass%.

12. The photosensitive composition according to claim 1, wherein the polymerizable compound is a compound with an ethylenically unsaturated bond, and the photopolymerization initiator is a photoradical polymerization initiator.

13. The photosensitive composition according to claim 1, wherein the polymerizable compound is a compound with a cationic polymerizable region, and the photopolymerization initiator is a photoacid generator.

14. A hologram recording layer obtained by coating the photosensitive composition according to claim 1 on a support.

15. A hologram recording medium, comprising: a support; a hologram recording layer obtained by coating the photosensitive composition according to claim 1 on the support; and a protective material covering an upper layer of the hologram recording layer.

16. The hologram recording medium according to claim 15, wherein the support and the protective material are both transparent resin films.

17. A pattern formation method, comprising the steps of: coating the photosensitive composition according to claim 1 on a support to form a coating film; and subjecting the coating film to pattern exposure.

18. The pattern formation method according to claim 17, wherein the pattern exposure is interference exposure.

19. A photosensitive composition **characterized by** comprising: (a) a polymerizable compound; (b) a photopolymerization initiator; and (c) organic fine particles, wherein a spatial refractive-index modulation pattern is formed through movement of the polymerizable compound and the organic fine particles by pattern exposure.

20. The photosensitive composition according to claim 19, **characterized in that** the organic fine particles are easily dissolved with the polymerizable compound.

21. The photosensitive composition according to claim 19, wherein a difference between a refractive index of the organic fine particles with respect to an interference exposure wavelength for hologram recording and a refractive index of the polymers with respect to an interference exposure wavelength for hologram recording is not less than 0.01 and not more than 1.0.

22. The photosensitive composition according to claim 19, wherein the organic fine particles have an average particle size that is not less than 1 nm and less than 100 nm.

23. The photosensitive composition according to claim 19, wherein the organic fine particles are hyperbranched polymers or dendrimers.

24. The photosensitive composition according to claim 23, wherein the organic fine particles are hyperbranched polymers represented by formula (1) or formula (2): 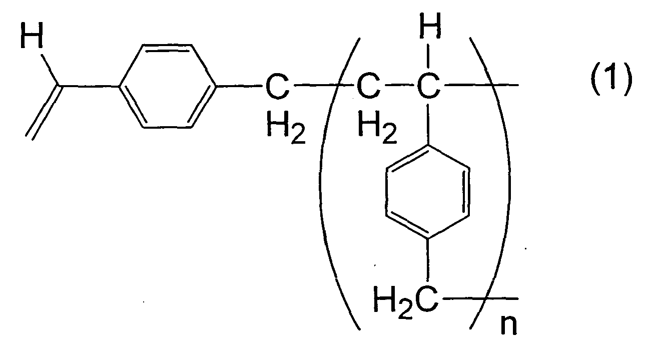 (wherein n indicates the number of repeated structural units, and is an integer from 2 to 100,000); and 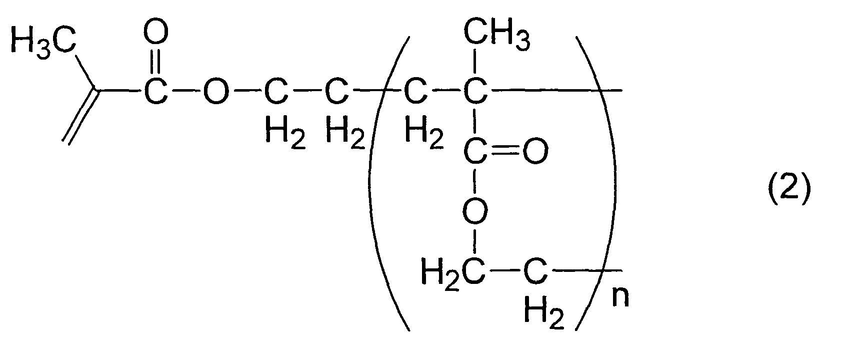 (wherein n indicates the number of repeated structural units, and is an integer from 2 to 100,000).
